# EUROPÄISCHE PATENTANMELDUNG

(11) **EP 1 083 409 A2**
(43) Veröffentlichungstag der Anmeldung: **14.03.2001**
(21) Anmeldenummer: 00115435.0
(22) Anmeldetag: 18.07.2000
(51) Int. Cl.: G01D 5/24

(54) **Kapazitiver Intrusionssensor und Sensorsystem mit einem solchen Sensor**

(30) Priorität: 11.09.1999 DE 19943618
(71) Anmelder: Bayerische Motoren Werke Aktiengesellschaft, 80809 München (DE)
(72) Erfinder: Lu,Yan,Dr., 85356 Freising (DE)

(57) **Zusammenfassung**

Die Erfindung betrifft einen kapazitiven Intrusionssensor und ein Sensorsystem mit einem solchen Sensor. Der kapazitive Intrusionssensor umfaßt zwei Sensorelektroden und zwei Guardelektroden, wobei jeweils eine Sensorelektrode und eine zugeordnete Guardelektrode elektrisch voneinander isoliert jedoch mit der gleichen Spannung versorgbar sind.

## Beschreibung

Die Erfindung betrifft einen kapazitiven Intrusionssensor gemäß dem Oberbegriff des Anspruchs 1 und ein Sensorsystem mit einem solchen Sensor.

Intrusionssensoren werden beispielsweise in der Automobilindustrie zur Detektion von Unfällen verwendet. Bekannt ist dabei der Einsatz von induktiven Intrusionssensoren, bei dem sich die Magneteigenschaft durch eine Verformung eines Fahrzeugteils verändert. Durch die Art der Magnetfeldänderung kann man auf die Unfallstärke schließen und Sicherheitsmaßnahmen für Fahrzeuginsassen treffen.

Problematisch bei induktiven Intrusionssensoren ist jedoch deren mangelnde Störfestigkeit. Befindet sich ein induktiver Intrusionssensor in einem externen Magnetfeld, wie es beispielsweise von einem Lautsprechermagneten erzeugt wird, so ändert sich seine Sensorinduktivität.

Befindet sich ein elektrisch leitender Gegenstand (z.B. ein metallischer Koffer) in der Nähe des Sensors, so werden Wirbelströme in dem elektrisch leitenden Gegenstand selbst erzeugt, was wiederum zu einer Änderung der Sensorinduktivität führt.

Ferner ist die Sensorinduktivität temperaturabhängig, weil sich unter Umständen die Leitfähigkeit des Meßobjektes mit der Temperatur ändert.

Alle vorgenannten Effekte führen dazu, daß Fehlinformationen erzeugt und darauf basierend Fehlauslösungen von Fahrzeugsicherheitssystemen hervorgerufen werden können.

Aus der WO 95/08752 ist ein kapazitiver Drucksensor bekannt, dessen zwei kapazitive Platten von Guardelektroden nach außen abgeschirmt sind. Allerdings lehrt die WO 95/08752, dass die Guardelektroden jeweils auf gleiches Potential gelegt werden. Somit sind sowohl für die Sensorelektroden wie auch für die Guardelektroden verschiedene Zuleitungen erforderlich.

Aufgabe der Erfindung ist es, einen weiteren Intrusionssensor und ein mit einem solchen Sensor arbeitendes Sensorsystem zu schaffen, der bzw. das auch bei Umgebungsänderungen funktionssicher ist.

Diese Aufgabe wird durch die im Anspruch 1 bzw. durch die im Anspruch 6 genannten Merkmale gelöst.

Ein Kerngedanke der Erfindung besteht darin, einen kapazitiven Intrusionssensor zu schaffen, der mittels zweier Guardelektroden, die auf dem gleichen Potential, wie die zugeordneten Sensorelektroden liegen, von Umwelteinflüssen abgeschirmt ist. Bei der erfindungsgemäßen Anordnung wird die Kapazität zwischen den beiden Elektroden, die vom Abstand der Elektroden abhängig ist, von der Umgebung im wesentlichen nicht beeinflußt, weil elektrische Felder, welche von der Guardelektrode und der Elektrode aufgebaut sind, voneinander getrennt sind und die Sensorelektroden durch die Guardelektroden von der Umgebung abgeschirmt sind. Lediglich, wenn in den Meßraum zwischen den beiden Sensorelektroden ein dielektrischer Gegenstand eintritt, kann dieser eine kleine Änderung der Sensorkapazität hervorrufen. Diese Kapazitätsänderung ist jedoch vernachlässigbar.

Gemäß einer bevorzugten Ausführungsform der Erfindung wird an eine Sensorelektrode eine positive Spannung +U und an die andere Sensorelektrode eine negative Spannung -U angelegt.

Weitere vorteilhafte Ausführungsformen sind in den Unteransprüchen definiert.

Bei dem erfindungsgemäßen Sensorsystem ist der kapazitive Intrusionssensor mit einer Spannungsquelle verbunden, die alle Elektroden mit der erforderlichen Spannung versorgt. Darüber hinaus ist eine Kapazitäts-Meßeinrichtung vorgesehen, die die Kapazität des Systems aus den beiden Sensorelektroden erfassen kann. Eine Auswerteeinheit bestimmt dann die Änderung der Kapazität.

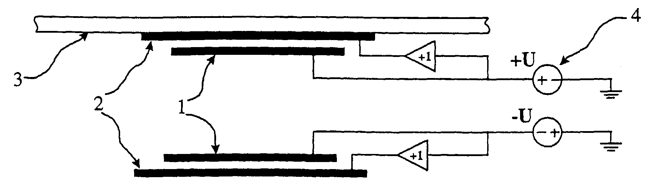

Eine einfache Ausführungsform der Erfindung wird nachfolgend und mit Bezug auf die einzige beiliegende Zeichnung beschrieben. Die Zeichnung stellt eine schematische Darstellung eines erfindungsgemäßen kapazitiven Intrusionssensors dar.

Die Zeichnung zeigt zwei Sensorelektroden 1, die in einem definierten Abstand parallel zueinander angeordnet sind. Dieser Abstand definiert zusammen mit den Sensorelektroden 1 die Kapazität des Sensorsystems. Ändert sich der Abstand zwischen den Sensorelektroden 1, so ändert sich auch die Kapazität des Systems.

Jeweils außerhalb der Sensorelektroden 1, d.h. an der der anderen Sensorelektrode gegenüberliegenden Seite, ist eine zugeordnete Guardelektrode 2 angeordnet. Jede Guardelektrode 2 ist gegenüber der zugeordneten Sensorelektrode 1 isoliert jedoch mit gleicher Spannung beaufschlagt. Im vorliegenden Fall sind die Sensorelektroden 1 und die Guardelektroden 2 über einen Operationsverstärker mit Verstärkung +1, der hier zum einen dieselbe Spannung an den Guardelektroden wie an den Sensorelektroden gewährleistet und zum anderen aufgrund seines sehr hohen ohmschen Eingangswiderstandes zur Trennung der Sensorelektrodenfelder von den Guardelektrodenfeldern dient, mit einer Spannungsquelle 4 verbunden und zwar derart, daß in der Zeichnung die oberen Elektroden mit der positiven Spannung +U und die in der Zeichnung unteren Elektroden mit der negativen Spannung -U versorgt werden. Durch diese Anordnung wird die Kapazität zwischen den beiden Elektroden von der Umgebung nicht beeinflußt, weil die Guardelektroden 2 die jeweils zugeordneten Sensorelektroden 1 im wesentlichen abschirmen.

Nicht dargestellt ist in der Zeichnung eine Kapazitäts-Meßeinrichtung und eine Auswerteeinheit zur Auswertung der Änderung der gemessenen Kapazität.

Das in der Zeichnung obere Elektrodenpaar ist im vorliegenden Fall mit einer Türversteifung oder einem Türaußenblech 3 verbunden. Das in der Zeichnung untere Elektroden paar mit einer Türinnenverkleidung oder einem Türinnenblech.

Bei einem Seitenaufprall wird die Türaußenseite verformt und der Abstand zwischen den beiden Sensorelektroden 1 verändert sich. Dadurch ändert sich die Kapazität. Diese Änderung wird erfaßt. Auf der Basis der erfaßten Änderung kann dann eine erforderliche Sicherheitsmaßnahme für Fahrzeuginsassen eingeleitet werden. Natürlich kann der vorliegende kapazitive Intrusionssensor auch in anderen Anwendungsgebieten verwendet werden.

Insgesamt weist der kapazitive Intrusionssensor gegenüber einem induktiven Sensor eine größere Reichweite und eine höhere Empfindlichkeit bei gleichbleibender Baugröße auf. Daher kann ein kapazitiver Intrusionssensor kleiner gebaut werden. Darüber hinaus ist der kapazitive Intrusionssensor gegenüber Umwelteinflüssen, wie Störfeldern, Temperatur etc. weniger anfällig. Nicht zuletzt sind die Materialkosten eines erfindungsgemäßen Sensors niedriger als bei einem induktiven Sensor.

## Patentansprüche

1. Kapazitiver Intrusionssensor mit zwei Sensorelektroden (1) und zwei Guardelektroden (2), wobei jeweils eine Sensorelektrode (1) und eine zugeordnete Guardelektrode (2) elektrisch voneinander isoliert sind und die beiden Guardelektroden (2) jeweils außerhalb der zugeordneten Sensorelektrode angeordnet sind,
dadurch gekennzeichnet,
daß jeweils eine Guardelektrode (2) und eine zugeordnete Sensorelektrode (1) mit der gleichen Spannung versorgbar sind.

2. Kapazitiver Intrusionssensor nach Anspruch 1,
dadurch gekennzeichnet,
daß eine positive Spannung (+U) an eine Sensorelektrode (1) und eine entsprechende negative Spannung (-U) an die andere Sensorelektrode (1) anlegbar sind.

3. Kapazitiver Intrusionssensor nach Anspruch 1 oder 2,
dadurch gekennzeichnet,
daß die beiden Sensorelektroden (1) parallel zueinander angeordnet sind.

4. Kapazitiver Intrusionssensor nach einem der Ansprüche 1 bis 3,
dadurch gekennzeichnet,
daß jede Gateelektrode (2) ihre zugeordnete Sensorelektrode (1) flachenmäßig zumindest im wesentlichen abdeckt.

5. Kapazitiver Intrusionssensor nach einem der vorhergehenden Ansprüchen,
dadurch gekennzeichnet,
daß eine Sensorelektrode (1) an einem zu überwachendem Objekt (3) und die andere Sensorelektrode (1) in definierter Entfernung dazu angeordnet ist.

6. Sensorsystem mit einem kapazitivem Intrusionssensor nach einem der vorhergehenden Ansprüche,
dadurch gekennzeichnet,
daß eine Spannungsversorgung vorgesehen ist, welche die beiden jeweils aus Sensorelektrode (1) und Guardelektrode (2) bestehenden Einheiten mit Spannung beaufschlagt, daß eine Kapazitäts-Meßeinrichtung zur Messung der Kapazität zwischen den beiden Sensorelektroden (1) und eine Auswerteeinheit zur Auswertung der Änderung der gemessenen Kapazität vorgesehen ist.
